(19) Europäisches Patentamt
European Patent Office
Office européen des brevets

(11) **EP 2 413 384 A2**

(12) **EUROPEAN PATENT APPLICATION**

(43) Date of publication:
**01.02.2012 Bulletin 2012/05**

(51) Int Cl.:
*H01L 31/073* (2012.01)    *H01L 31/18* (2006.01)

(21) Application number: **11174089.0**

(22) Date of filing: **15.07.2011**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **28.07.2010 US 844931**

(71) Applicant: **General Electric Company Schenectady, NY 12345 (US)**

(72) Inventors:
• **Ahmad, Faisal Razi**
**Niskayuna, NY New York 12309 (US)**

• **Korevaar, Bastiaan Arie**
**Niskayuna, NY New York 12309 (US)**
• **Bray, James William**
**Niskayuna, NY New York 12309 (US)**
• **Metzger, Wyatt Keith**
**Louisville, CO Colorado 80027 (US)**

(74) Representative: **Bedford, Grant Richard**
**GE International Inc.**
**Global Patent Operation-Europe**
**15 John Adam Street**
**London**
**WC2N 6LU (GB)**

(54) **Photovoltaic device**

(57)    A photovoltaic device 100 is provided. The device 100 comprises a transparent conducting layer 110. A p-type semiconductor window layer 112 is disposed over the n-type transparent conducting layer. An n-type semiconductor layer 114 is disposed over the p-type semiconductor window layer 112. An n-type cadmium telluride absorber layer 116 is disposed between the p-type semiconductor window layer 112 and the n-type semiconductor layer 114.

FIG. 1

EP 2 413 384 A2

**Description**

The invention relates generally to the field of photovoltaics. In particular, the invention relates to a group of layers used in solar cells and a solar cell made therefrom.

Solar energy is abundant in many parts of the world year around. Unfortunately, the available solar energy is not generally used efficiently to produce electricity. The cost of conventional solar cells, and electricity generated by these cells, is generally very high. For example, a typical solar cell achieves a conversion efficiency of less than 20 percent. Moreover, solar cells typically include multiple layers formed on a substrate, and thus solar cell manufacturing typically requires a significant number of processing steps. As a result, the high number of processing steps, layers, interfaces, and complexity increase the amount of time and money required to manufacture these solar cells.

Accordingly, there remains a need for an improved solution to the long-standing problem of inefficient and complicated solar energy conversion devices and methods of manufacture.

In one embodiment, according to the present invention a photovoltaic device is provided. The device comprises a transparent conducting layer. A p-type semiconductor window layer is disposed over the transparent conducting layer. An n-type semiconductor layer is disposed over the p-type semiconductor window layer. An n-type cadmium telluride absorber layer is disposed between the p-type semiconductor window layer and the n-type semiconductor layer.

In one embodiment, a photovoltaic device is provided. The device comprises an n-type transparent conducting layer. A p-type semiconductor window layer is disposed over the n-type transparent conducting layer. An n-type semiconductor layer is disposed over the p-type semiconductor window layer. An n-type cadmium telluride absorber layer is disposed between the p-type semiconductor window layer and the n-type semiconductor layer.

In another embodiment, is provided a photovoltaic device. The device comprises an n-type transparent conducting layer. A p-type transparent conducting layer is disposed over the n-type transparent conducting layer. A p-type magnesium telluride window layer is disposed over the p-type transparent conducting layer. An n-type cadmium telluride layer having a dopant density of greater than about $1 \times 10^{17}$ per cubic centimeter is disposed over the p-type transparent conducting layer. An n-type cadmium telluride absorber layer having a dopant density in the range of about $1 \times 10^{15}$ per cubic centimeter to about $1 \times 10^{16}$ per cubic centimeter is disposed between the p-type magnesium telluride layer and the n-type cadmium telluride layer having a dopant density of greater than about $1 \times 10^{17}$ per cubic centimeter.

In yet another embodiment, is provided a photovoltaic device. The device comprises an n-type transparent conducting layer. A p-type semiconductor window layer having a dopant density of greater than about $1 \times 10^{18}$ per cubic centimeter is disposed over the n-type transparent conducting layer. An n-type semiconductor layer having a dopant density of greater than about $1 \times 10^{17}$ per cubic centimeter is disposed over the p-type semiconductor window layer. An n-type cadmium telluride absorber layer having a dopant density in a range of about $1 \times 10^{15}$ per cubic centimeter to about $1 \times 10^{16}$ per cubic centimeter is disposed between the p-type semiconductor window layer and the n-type layer having a dopant density of greater than about $1 \times 10^{17}$ per cubic centimeter.

In still yet another embodiment, is provided a photovoltaic device. The device comprises a first n-type transparent conducting layer. A p-type semiconductor window layer having a dopant density of greater than about $1 \times 10^{18}$ per cubic centimeter is disposed over the first n-type transparent conducting layer. A second n-type transparent conducting layer is disposed over the p-type semiconductor window layer. An n-type cadmium telluride absorber layer having a dopant density in the range of about $1 \times 10^{15}$ per cubic centimeter to about $1 \times 10^{16}$ per cubic centimeter is disposed between the p-type semiconductor window layer and the second n-type transparent conducting layer.

In still yet another embodiment, a photovoltaic device is provided. The device comprises a p-type transparent conducting layer. A p-type semiconductor window layer is disposed over the p-type transparent conducting layer. An n-type semiconductor layer is disposed over the p-type semiconductor window layer. An n-type cadmium telluride absorber layer is disposed between the p-type semiconductor window layer and the n-type semiconductor layer.

Various features, aspects, and advantages of the present invention will become better understood when the following detailed description is read with reference to the accompanying drawings in which like characters represent like parts throughout the drawings, wherein:

Figure 1 illustrates a schematic of a photovoltaic device in accordance with one embodiment of the invention;

Figure 2 illustrates a schematic of a photovoltaic device in accordance with one embodiment of the invention;

Figure 3 illustrates a schematic of a photovoltaic device in accordance with one embodiment of the invention;

Figure 4 illustrates a schematic of a photovoltaic device in accordance with one embodiment of the invention;

Figure 5 illustrates a schematic of a photovoltaic device in accordance with one embodiment of the invention;

Figure 6 illustrates a schematic of a photovoltaic device in accordance with one embodiment of the invention;

Figure 7 illustrates a schematic of a photovoltaic device in accordance with one embodiment of the invention;

Figure 8 illustrates a schematic of a photovoltaic device in accordance with one embodiment of the invention;

Figure 9 illustrates a schematic of a photovoltaic device in accordance with one embodiment of the invention;

Figure 10 illustrates a schematic of a photovoltaic device in accordance with one embodiment of the invention;

Figure 11 illustrates a schematic of a photovoltaic device in accordance with one embodiment of the invention;

Figure 12 illustrates a schematic of a photovoltaic device in accordance with one embodiment of the invention;

Figure 13 illustrates a schematic of a photovoltaic device in accordance with one embodiment of the invention;

Figure 14 illustrates a schematic of a method to make a layer of a photovoltaic device as shown in Figure 4 in accordance with certain embodiments of the present invention; and

Figure 15 illustrates a schematic of a method to make a layer of a photovoltaic device as shown in Figure 7 in accordance with certain embodiments of the present invention.

The invention relates generally to the field of photovoltaics. In particular, various aspects and embodiments of the invention relate to a group of layers used in solar cells and a solar cell made therefrom.

Despite significant academic and industrial research and development effort, the best efficiencies reported for cadmium telluride photovoltaic devices have been stagnant, for about decade, at about 16 percent. The efficiency of a cadmium telluride photovoltaic device module fabricated from such cadmium telluride photovoltaic devices, and designed to provide useful amounts of electricity (for household applications, for example), can be significantly lower. It has been estimated that a cadmium telluride photovoltaic device efficiency in excess of about 20 percent can be achieved. However, there are a few challenges in trying to achieve an efficiency of about 20 percent. One of the challenges includes achieving a high hole carrier concentration in p-type cadmium telluride either by using native or extrinsic dopants. Further, due to the large work function of p-type cadmium telluride it has so far been a serious challenge to form a stable and low contact resistance contact on the back of the cell.

Additional challenges may be associated with the cadmium sulfide window layer that is typically employed in combination with a p-type cadmium telluride absorber layer. Conventional explanation for the photovoltaic operation of a cadmium sulfide/cadmium telluride is based on the junction formation at the interface between the n-type cadmium sulfide and p-type cadmium telluride. Unfortunately, due to the presence of a host of secondary effects, for example, sulfur diffusion from the cadmium sulfide, presence of the piezo-effect, lattice mismatch, different crystal orientation between cadmium telluride and cadmium sulfide, and the presence of defect states at the interface, may result in a poor junction which translates in an open-circuit voltage that is lower than expected from theoretical calculations.

Various embodiments of the invention described herein address the noted shortcomings of the state of the art. One device described herein fills the needs described above by employing an n-type cadmium telluride layer that will permit the addition of active dopants to the layer and hence result in higher open-circuit voltage, thereby providing a device with improved efficiency. In one embodiment, the device includes an n-type cadmium telluride absorber layer disposed between a p-type semiconductor window layer and an n-type semiconductor layer. Appreciating that this group of layers forms the required junctions in the device changes the concept of how one can improve these devices.

One or more specific embodiments of the present invention will be described below. In an effort to provide a concise description of these embodiments, all features of an actual implementation may not be described in the specification. It should be appreciated that in the development of any such actual implementation, as in any engineering or design project, numerous implementation-specific decisions must be made to achieve the developers' specific goals, such as compliance with system-related and business-related constraints, which may vary from one implementation to another. Moreover, it should be appreciated that such a development effort might be complex and time consuming, but would nevertheless be a routine undertaking of design, fabrication, and manufacture for those of ordinary skill having the benefit of this disclosure.

When introducing elements of various embodiments of the present invention, the articles "a," "an," "the," and "said" are intended to mean that there are one or more of the elements. The terms "comprising," "including," and "having" are intended to be inclusive and mean that there may be additional elements other than the listed elements. Moreover, the use of "top," "bottom," "above," "below," and variations of these terms is made for convenience, but does not require any particular orientation of the components unless otherwise stated. As used herein, the terms "disposed over" or "deposited over" or "disposed between" refers to both secured or disposed directly in contact with and indirectly by having intervening layers therebetween.

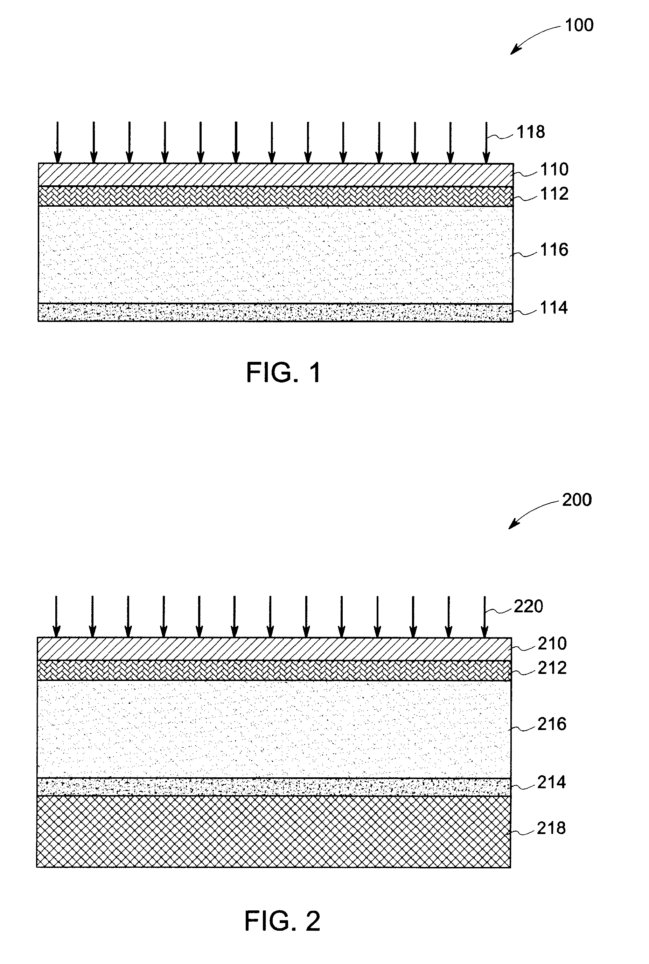

As illustrated in Figure 1, in one embodiment, a photovoltaic device 100 is provided. The device 100 comprises a transparent conducting layer 110. A p-type semiconductor window layer 112 is disposed over the transparent conducting layer 110. An n-type semiconductor layer 114 is disposed over the p-type semiconductor window layer 112. An n-type cadmium telluride absorber layer 116 is disposed between the p-type semiconductor window layer 112 and the n-type semiconductor layer 114. Light 118 enters the device 100 through the transparent conducting layer 110 and the p-type semiconductor window layer 112. Using an n-type cadmium telluride absorber material may be advantageous. As known in the art, n-type cadmium telluride can be doped to higher carrier densities than p-type cadmium telluride. A higher build-in voltage may be achieved using the n-type cadmium telluride having higher carrier densities. For example, as known to one skilled in the art carrier density in p-type cadmium telluride less than or equal to about $2 \times 1 \times 10^{16}$ per cubic centimeter. On the other hand the carrier densities of up to about $1 \times 10^{15}$ per cubic centimeter to about $1 \times 10^{16}$ per cubic centimeter may be achieved in an n-type cadmium telluride.

In one embodiment, the transparent conducting layer 110 comprises an n-type transparent conducting layer. In one embodiment, the n-type transparent conducting layer comprises at least one transparent conducting oxide selected from the group consisting of indium tin oxide, indium oxide, tin oxide, zinc oxide, aluminum doped zinc oxide, gallium doped zinc oxide, fluorine doped tin oxide, and indium zinc oxide.

In one embodiment, a dopant density within the n-type transparent conducting layer is in a range from about $1 \times 10^{19}$ per cubic centimeter to about $1 \times 10^{21}$ per cubic centimeter. In another embodiment, a dopant density within the n-type transparent conducting layer is greater than about $1 \times 10^{20}$ per cubic centimeter.

In one embodiment, the n-type transparent conducting layer 110 has a thickness of less than or equal to about 500 nanometers. In another embodiment, the n-type transparent conducting layer 110 has a thickness of less than or equal to about 300 nanometers. In yet another embodiment, the n-type transparent conducting layer 110 has a thickness of less than or equal to about 200 nanometers.

In one embodiment, the transparent conducting layer 110 comprises a p-type transparent conducting layer. In one embodiment, the p-type transparent conducting layer comprises BaCuEF, LaCuOD, $MCuO(S_{1-y},Se_y)$, strontium copper zinc oxy sulfide ($Sr_2Cu_2ZnO_2S_2$) or strontium copper gallium oxy sulfide ($Sr_2CuGaO_3S$), wherein 'E' comprises sulfur, selenium, or tellurium, wherein 'D' comprises sulfur, selenium, or tellurium, wherein 'M' comprises praseodymium, neodymium, or a lanthanide and wherein y has a value of 0 or less than or equal 1. In one embodiment, the p-type transparent conducting layer 110 comprises a class of materials called 'delafossites' which include copper aluminum oxide ($CuAlO_2$) and strontium copper oxide ($SrCu_2O_2$).

In one embodiment, a dopant density within the p-type transparent conducting layer is in a range from about $1 \times 10^{18}$ per cubic centimeter to about $1 \times 10^{20}$ per cubic centimeter. In another embodiment, a dopant density within the p-type transparent conducting layer is in a range from about $1 \times 10^{19}$ to $1 \times 10^{20}$ per cubic centimeter.

In one embodiment, the p-type transparent conducting layer has a thickness of less than or equal to about 500 nanometers. In another embodiment, the p-type transparent conducting layer has a thickness of less than or equal to about 300 nanometers. In yet another embodiment, the p-type transparent conducting layer has a thickness of less than or equal to about 100 nanometers. In still yet another embodiment, the p-type transparent conducting layer has a thickness of less than or equal to about 50 nanometers.

In one embodiment, the p-type semiconductor window layer 112 and the n-type cadmium telluride layer 116 each have a corresponding band-gap. In one embodiment, the band-gap of the p-type semiconductor window layer 112 is greater than the band-gap of the n-type cadmium telluride layer 116. In one embodiment, the p-type semiconductor window layer 112 comprises a material having a band-gap in a range from about 1.5 electron Volts to about 3.7 electron Volts. In another embodiment, the p-type semiconductor window layer 112 comprises a material having a band-gap in a range from about 1.7 electron Volts to about 3.5 electron Volts. In yet another embodiment, the p-type semiconductor window layer 112 comprises a material having a band-gap in a range from about 2.1 electron Volts to about 3.4 electron Volts. Suitable examples of materials used for the p-type semiconductor window layer 112 include zinc telluride, magnesium telluride, magnesium selenide, zinc-magnesium-sulfide-selenide (ZnMgSSe), nitrogen doped zinc-magnesium-beryllium-selenide (ZnMgBeSe:N), copper oxide ($Cu_2O$), hydrogenated amorphous silicon, amorphous silicon carbide (a-SiC:H), BaCuEF, LaCuOD, MCuO($S_{1-y}$,$Se_y$), strontium copper zinc oxy sulfide ($Sr_2Cu_2ZnO_2S_2$) or strontium copper gallium oxy sulfide ($Sr_2CuGaO_3S$), wherein 'E' comprises sulfur, selenium, or tellurium, wherein 'D' comprises sulfur, selenium, or tellurium, wherein 'M' comprises praseodymium, neodymium, or a lanthanide and wherein y has a value of 0 or less than or equal 1. In one embodiment, the semiconductor window layer 112 comprises copper aluminum

oxide ($CuAlO_2$) or strontium copper oxide ($SrCu_2O_2$).

In one embodiment, a dopant density within the p-type semiconductor window layer 112 is in a range from about $1 \times 10^{13}$ per cubic centimeter to about $1 \times 10^{19}$ per cubic centimeter. In another embodiment, a dopant density within the p-type semiconductor window layer 112 is in a range from about $1 \times 10^{14}$ per cubic centimeter to about $1 \times 10^{18}$ per cubic centimeter. In yet another embodiment, a dopant density within the p-type semiconductor window layer 112 is in a range from about $1 \times 10^{15}$ per cubic centimeter to about $1 \times 10^{17}$ per cubic centimeter.

In one embodiment, the p-type semiconductor window layer 112 has a thickness of less than or equal to about 500 nanometers. In another embodiment, the p-type semiconductor window layer 112 has a thickness of less than or equal to about 300 nanometers. In yet another embodiment, the p-type semiconductor window layer 112 has a thickness of less than or equal to about 100 nanometers. In still yet another embodiment, the p-type semiconductor window layer 112 has a thickness of less than or equal to about 50 nanometers.

In one embodiment, the n-type cadmium telluride absorber layer comprises a dopant material comprising cadmium, aluminum, indium, iodine, or gallium. In one embodiment, a dopant density within the n-type cadmium telluride absorber layer is in a range from about $1 \times 10^{15}$ per cubic centimeter to about $1 \times 10^{17}$ per cubic centimeter. In one embodiment, the dopant density within the n-type cadmium telluride absorber layer is about $1 \times 10^{16}$ per cubic centimeter.

CdTe is a prominent polycrystalline thin-film material, with a nearly ideal bandgap of about 1.45 electron volts to about 1.5 electron volts. CdTe also has a very high absorptivity. Although CdTe is most often used in photovoltaic devices without being alloyed, it can be alloyed with zinc, magnesium, manganese, and a few other elements to vary its electronic and optical properties. Films of CdTe can be manufactured using low-cost techniques.

The cadmium telluride may, in certain embodiments, comprise other elements from the Group II and Group VI or Group III and Group V that may not result in large bandgap shifts. In one embodiment, the bandgap shift is less than or equal to about 0.1 electron Volts for the absorber layer. In one embodiment, the atomic percent of zinc or magnesium in cadmium telluride is less than about 10 atomic percent. In another embodiment, the atomic percent of zinc or magnesium in cadmium telluride is up to about 8 atomic percent. In yet another embodiment, the atomic percent of zinc or magnesium in cadmium telluride is up to about 6 atomic percent.

In one embodiment, the n-type cadmium telluride absorber layer 116 has a thickness of less than or equal to about 6 micrometers. In another embodiment, the n-type cadmium telluride absorber layer 116 has a thickness of less than or equal to about 3 micrometers. In yet another embodiment, the n-type cadmium telluride absorber layer 116 has a thickness of less than or equal to about 2 micrometers.

In one embodiment, the n-type semiconductor layer 114 and the n-type cadmium telluride layer 116 each have a corresponding band-gap. The band-gap of the n-type semiconductor layer 114 is greater than or equal to the band-gap of the n-type cadmium telluride layer 116. In one embodiment, the n-type semiconductor layer comprises a material having a band-gap in a range from about 1.4 electron Volts to about 2.5 electron Volts. In another embodiment, the n-type semiconductor layer comprises a material having a band-gap in a range from about 1.5 electron Volts to about 2.4 electron Volts. In yet another embodiment, the n-type semiconductor layer comprises a material having a band-gap in a range from about 1.8 electron Volts to about 2.2 electron Volts. Suitable examples of materials used for the n-type semiconductor layer 114 include cadmium telluride, cadmium sulfide, cadmium zinc telluride, zinc telluride, cadmium selenide, zinc selenide, or n-type hydrogenated amorphous silicon.

In one embodiment, a dopant density within the n-type semiconductor layer 114 is in a range from about $1 \times 10^{16}$ per cubic centimeter to about $1 \times 10^{21}$ per cubic centimeter. In another embodiment, a dopant density within the n-type semiconductor layer 114 is in a range from about $1 \times 10^{17}$ per cubic centimeter to about $1 \times 10^{20}$ per cubic centimeter. In yet another embodiment, a dopant density within the n-type semiconductor layer 114 is in a range from about $1 \times 10^{18}$ per cubic centimeter to about $1 \times 10^{19}$ per cubic centimeter. In one embodiment, suitable dopant materials that can be used with an n-type semiconductor layer include cadmium, indium, gallium, or aluminum. In one embodiment, the n-type semiconductor layer 114 is an n-type cadmium telluride layer 516 with suitable dopant materials.

In one embodiment, the n-type semiconductor layer 114 has a thickness of less than or equal to about 500 nanometers. In another embodiment, the n-type semiconductor layer 114 has a thickness of less than or equal to about 300 nanometers. In yet another embodiment, the n-type semiconductor layer 114 has a thickness of less than or equal to about 200 nanometers. In still yet another embodiment, the n-type semiconductor layer 114 has a thickness of less than or equal to about 100 nanometers.

In certain embodiments, the device includes a back contact layer 218. Referring to Figure 2, in one embodiment, a photovoltaic device 200 is provided. The device 200 includes an n-type transparent conducting layer 210. A p-type semiconductor window layer 212 is disposed over the n-type transparent conducting layer 210. An n-type semiconductor layer 214 is disposed over the p-type semiconductor window layer 212. An n-type cadmium telluride absorber layer 216 is disposed between the p-type semiconductor window layer 214 and the n-type semiconductor layer 216. The back contact layer 218 is disposed over the n-type semiconductor layer 214.

Light 220 enters the device 200 through the n-type transparent conducting layer 210 and the p-type semiconductor window layer 212. The back contact layer 218 may comprise a metal, a semiconductor, or other appropriately electrically conductive material. In one embodiment, the back contact layer 218 comprises a material selected from the group consisting of silver, copper, molybdenum, aluminum, copper aluminum alloy, silver copper alloy, and copper molybdenum alloy. In some embodiments, the n-type cadmium telluride absorber layer 216 and the back contact layer 218 are disposed in a manner such that the absorber layer 216 is immediately adjacent to the back contact layer 218 without the intervening n-type semiconductor layer 214.

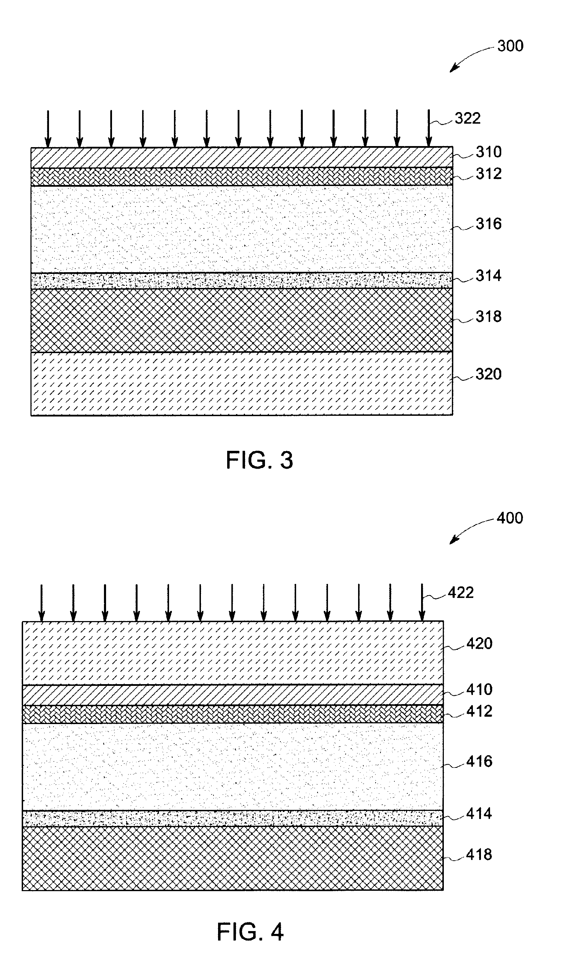

In one embodiment, the photovoltaic device 300 comprises a substrate 320 disposed over a back contact layer 318. In the illustrated embodiment in Figure 3 a photovoltaic device 300 is provided. The device 300 includes an n-type transparent conducting layer 310. A p-type semiconductor window layer 312 is disposed over the n-type transparent conducting layer 310. An n-type semiconductor layer 314 is disposed over the p-type semiconductor window layer 312. An n-type cadmium telluride absorber layer 316 is disposed between the p-type semiconductor window layer 314 and the n-type semiconductor layer 316. The back contact layer 318 is disposed over the n-type semiconductor layer 314. A substrate 320 is disposed over the back contact layer 318. Light 322 enters the photovoltaic device through the n-type transparent conducting layer 310 and the p-type semiconductor window layer 312. In certain embodiments, the back contact layer 318 may function as the substrate 320.

The configuration of the layers illustrated in Figure 3 may be referred to as a "substrate" configuration. The n-type transparent conducting layer 310 may be considered as the front contact layer in the device 300. Since, in this embodiment, the substrate layer 320 is in contact with the back contact layer 318, the substrate layer 320 may include an opaque substrate or a transparent substrate. Suitable examples of materials used for the substrate layer 320 in the illustrated configuration include glass, metal, or a polymer. In one embodiment, the polymer comprises a transparent polycarbonate or a polyimide. In one embodiment, the metal may include any metal that can be employed as a substrate in a photovoltaic device as known to one skilled in the art. The metal 320 disposed on the back contact layer 318 helps in improving the electrical contact. The front and the back contact layers are generally used to carry the electric current out to an external load and back into the device, thus completing an electric circuit.

As illustrated in Figure 4, in one embodiment, the photovoltaic device 400 comprises an n-type transparent conducting layer 410 disposed over a substrate 420. A p-type semiconductor window layer 412 is disposed over the n-type transparent conducting layer 410. An n-type semiconductor layer 414 is disposed over the p-type semiconductor window layer 412. An n-type cadmium telluride absorber layer 416 is disposed between the p-type semiconductor window layer 412 and the n-type semiconductor layer 414. The back contact layer 418 is disposed over the n-type semiconductor layer 414. Light 422 enters the photovoltaic device through the substrate 420 and then passes through the n-type transparent conducting layer 410 and the p-type semiconductor window layer 412.

The configuration of the layers illustrated in Figure 4 may be referred to as a "superstrate" configuration since the light 422 enters from the substrate 420 and then passes on into the device. Since, in this embodiment, the substrate layer 420 is in contact with the n-type transparent conducting layer 410, the substrate layer 420 is generally sufficiently transparent for visible light to pass through the substrate layer 420 and come in contact with the n-type transparent conducting layer 410 and the p-type semiconducting window layer 412. In one embodiment, the n-type transparent conducting layer 410, may function as a front contact layer. Suitable examples of materials used for the substrate layer 420 in the illustrated configuration include glass or a polymer. In one embodiment, the polymer comprises a transparent polycarbonate or a polyimide.

As used herein the term "dopant materials" means that the dopant employed comprises a foreign material different to the material in the bulk of a semiconductor material. The foreign material may be considered as impurities willfully introduced in the material. The dopant materials in a layer render the layers either p-type or n-type. As used herein the phrase "dopant density" means the resultant doping concentration of a layer based on both the acceptor states and the donor states that are present in the layer on account of various types of defects and willfully introduced impurities present in the layer. In one embodiment, the defects are inherent in the layers based on the method of manufacturing while the impurities may be introduced in the layers during the manufacturing process as discussed herein.

In one embodiment, a p-type transparent conducting layer 512 is disposed between the n-type transparent conducting layer 510 and the p-type semiconductor window layer 514. The advantage of disposing a p-type transparent conducting layer 512 between the n-type transparent conducting layer 510 and the p-type semiconductor window layer 514 is that doing so allows for optimizing the p-type semiconductor with respect to the n-type cadmium telluride interface. For example, magnesium telluride or magnesium cadmium telluride may be used as the p-type transparent conducting layer 512. Magnesium telluride cannot be doped to render it more p-type i.e., a p+-type. But magnesium telluride has a good lattice match with cadmium telluride. Thus the defects at the interface of the p-type semiconductor window layer and the n-type cadmium telluride absorber layer are minimized. The more p-type the layer, the better is the capability of the layer to cancel out the gap in work-function of the layer and the cadmium telluride absorber layer. The p+-type transparent conducting layer may completely deplete the p-type semiconductor layer and generate the field into the n-type cadmium telluride absorber layer, though physically the charge is separated at the defect free interface. As used herein the term "p+-type" implies a p-type semiconductor layer in which there is excess mobile hole concentration.

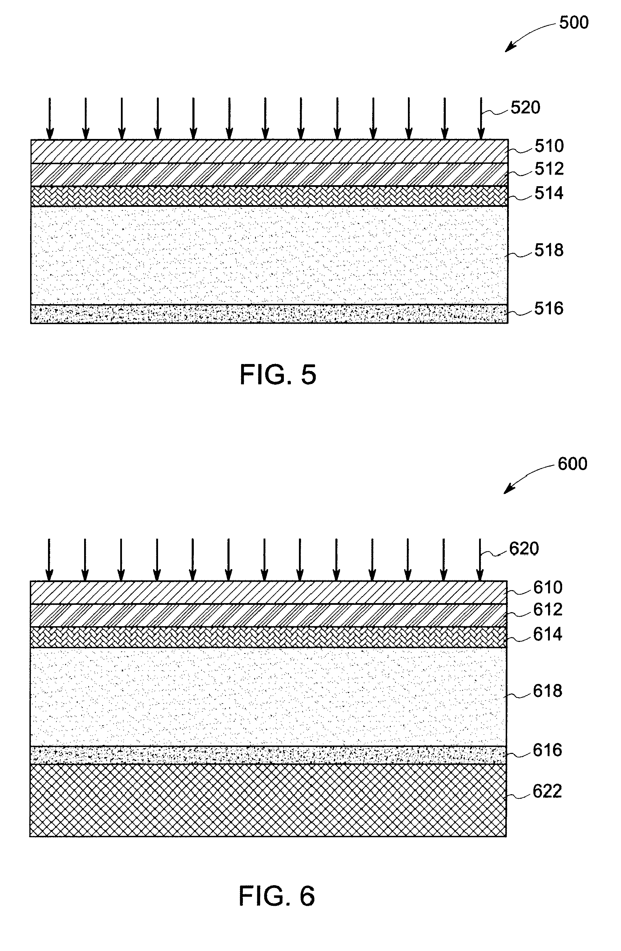

As illustrated in Figure 5, a photovoltaic device 500 is provided. The device 500 comprises an n-type transparent conducting layer 510. A p-type transparent conducting layer 512 is disposed on the n-type transparent conducting layer 510. A p-type semiconductor window layer 514 is disposed over the p-type transparent conducting layer 512. An n-type semiconductor layer 516 is disposed over the p-type semiconductor window layer 514. An n-type cadmium telluride absorber layer 518 is disposed between the p-type semiconductor window layer 514 and the n-type semiconductor layer 516. Light 520 enters the device 500 through the n-type transparent conducting layer 510, the p-type transparent conducting layer 512 and the p-type semiconductor window layer 514. In one embodiment, the n-type semiconductor layer 516, is a cadmium telluride layer having a dopant density of greater than about from about $1 \times 10^{17}$ per cubic centimeter and the n-type cadmium telluride layer 518 has a dopant density in a range from about $1 \times 10^{15}$ per cubic centimeter to about $1 \times 10^{16}$ per cubic centimeter. In one embodiment, the p-type semiconductor window layer 514 is a magnesium telluride layer.

In one embodiment, a dopant density within the p-type transparent conducting layer 512 is in a range from about $1 \times 10^{18}$ per cubic centimeter to about $1 \times 10^{20}$ per cubic centimeter. In another embodiment, a dopant density within the p-type transparent conducting layer 512 is in a range from about $1 \times 10^{19}$ to $1 \times 10^{20}$ per cubic centimeter.

In one embodiment, the p-type transparent conducting layer 512 comprises BaCuEF, LaCuOD, MCuO $(S_{1-y}, Se_y)$, strontium copper zinc oxy sulfide $(Sr_2Cu_2ZnO_2S_2)$ or strontium copper gallium oxy sulfide $(Sr_2CuGaO_3S)$, wherein 'E' comprises sulfur, selenium, or tellurium, wherein 'D' comprises sulfur, selenium, or tellurium, wherein 'M' comprises praseodymium, neodymium, or a lanthanide and wherein y has a value of 0 or less than or equal 1. In one embodiment, the p-type transparent conducting layer 512 comprises copper aluminum oxide $(CuAlO_2)$ and strontium copper oxide $(SrCu_2O_2)$.

In one embodiment, the p-type transparent conducting layer 512 has a thickness of less than or equal to about 500 nanometers. In another embodiment, the p-type transparent conducting layer 512 has a thickness of less than or equal to about 300 nanometers. In yet another embodiment, the p-type transparent conducting layer 512 has a thickness of less than or equal to about 100 nanometers. In still yet another embodiment, the p-type transparent conducting layer 512 has a thickness of less than or equal to about 50 nanometers.

In one embodiment, a back contact layer 622 may be disposed on the n-type semiconductor layer 616. As illustrated in Figure 6, a photovoltaic device 600 is provided. The device 600 comprises an n-type transparent conducting layer 610. A p-type transparent conducting layer 612 is disposed on the n-type transparent conducting layer 610. A p-type semiconductor window layer 614 is disposed over the p-type transparent conducting layer 612. An n-type semiconductor layer 616 is disposed over the p-type semiconductor window layer 614. An n-type cadmium telluride absorber layer 618 is disposed between the p-type semiconductor window layer 614 and the n-type semiconductor layer 616. Light 620 enters the device 600 through the n-type transparent conducting layer 610, the p-type transparent conducting layer 612 and the p-type semiconductor window layer 614. A back contact layer 622 may then be disposed on the n-type semiconductor layer 616. In one embodiment, the n-type semiconductor layer 616, is a cadmium telluride layer having a dopant density of greater than about from about $1 \times 10^{17}$ per cubic centimeter and the n-type cadmium telluride layer 618 has a dopant density in a range from about $1 \times 10^{15}$ per cubic centimeter to about $1 \times 10^{16}$ per cubic centimeter. In one embodiment, the p-type semiconductor window layer 614 is a magnesium telluride layer.

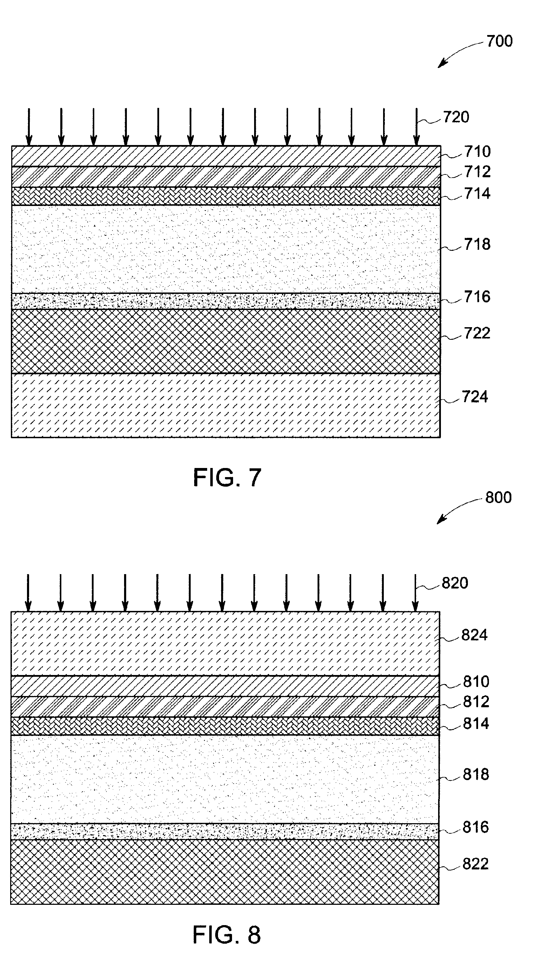

In one embodiment, a substrate 724 may be disposed over the back contact layer 722. As discussed above, the configuration of the layers when the substrate is disposed over the back contact layer is a "substrate" configuration. As illustrated in Figure 7, a photovoltaic device 700 is provided. The device 700 comprises an n-type transparent conducting layer 710. A p-type transparent conducting layer 712 is disposed on the n-type transparent conducting layer 710. A p-type semiconductor window layer 714 is disposed over the p-type transparent conducting layer 712. An n-type semiconductor layer 716 is disposed over the p-type semiconductor window layer 714. An n-type cadmium telluride absorber layer 718 is disposed between the p-type semiconductor window layer 714 and the n-type semiconductor layer 716. Light 720 enters the device 700 through the n-type transparent conducting layer 710, the p-type transparent conducting layer 712 and the p-type semiconductor window layer 714. A back contact layer 722 is disposed over the n-type semiconductor layer 716. A substrate 724 is disposed over the back contact layer 722. In one embodiment, the n-type semiconductor layer 716, is a cadmium telluride layer having a dopant density of greater than about from about $1 \times 10^{17}$ per cubic centimeter and the n-type cadmium telluride layer 718 has a dopant density in a range from about $1 \times 10^{15}$ per cubic centimeter to about $1 \times 10^{16}$ per cubic centimeter. In one embodiment, the p-type semiconductor window layer 714 is a magnesium telluride layer.

In one embodiment, an n-type transparent conducting layer 810 may be disposed over a substrate 824.

As discussed above, the configuration of the layers when the n-type transparent conducting layer is disposed over the substrate is a "superstrate" configuration. As illustrated in Figure 8, a photovoltaic device 800 is provided. The device 800 comprises an n-type transparent conducting layer 810 disposed over a substrate 824. A p-type transparent conducting layer 812 is disposed on the n-type transparent conducting layer 810. A p-type semiconductor window layer 814 is disposed over the p-type transparent conducting layer 812. An n-type semiconductor layer 816 is disposed over the p-type semiconductor window layer 814. An n-type cadmium telluride absorber layer 818 is disposed between the p-type semiconductor window layer 814 and the n-type semiconductor layer 816. Light 820 enters the device 800 through the n-type transparent conducting layer 810, the p-type transparent conducting layer 812 and the p-type semiconductor window layer 814. A back contact layer 822 is disposed over the n-type semiconductor layer 816. In one embodiment, the n-type semiconductor layer 816, is a cadmium telluride layer having a dopant density of greater than about from about $1 \times 10^{17}$ per cubic centimeter and the n-type cadmium telluride layer 818 has a dopant density in a range from about $1 \times 10^{15}$ per cubic centimeter to about $1 \times 10^{16}$ per cubic centimeter. In one embodiment, the p-type semiconductor window layer 814 is a magnesium telluride layer.

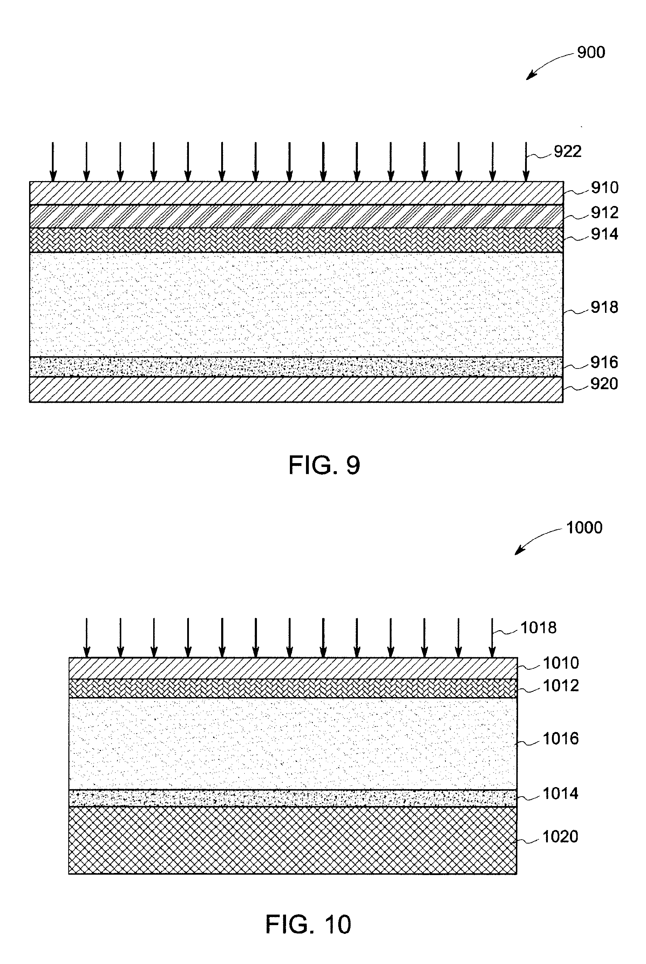

In one embodiment, the photovoltaic device described in Figure 5, further comprises an n-type transparent conducting layer 920 disposed over an n-type transparent conducting layer 916. As illustrated in Figure 9, a photovoltaic device 900 is provided. The device 900 comprises an n-type transparent conducting layer 910. A p-type transparent conducting layer 912 is disposed on the n-type transparent conducting layer 910. A p-type semiconductor window layer 914 is disposed over the p-type transparent conducting layer 912. An n-type semiconductor layer 916 is disposed over the p-type semiconductor window layer 914. An n-type cadmium telluride absorber layer 918 is disposed between the p-type semiconductor window layer 914 and the n-type semiconductor layer 916. An n-type transparent conducting layer 920 is disposed over the n-type semiconductor layer 916. Light 922 enters the device 900 through the n-type transparent conducting layer 910, the p-type transparent conducting layer 912 and the p-type semiconductor window layer 914. In one embodiment, the n-type semiconductor layer 916, is a cadmium telluride layer having a dopant density of greater than about from about $1 \times 10^{17}$ per cubic centimeter and the n-type cadmium telluride layer 918 has a dopant density in a range from about $1 \times 10^{15}$ per cubic centimeter to about $1 \times 10^{16}$ per cubic centimeter. In one embodiment, the p-type semiconductor window layer 914 is a magnesium telluride layer.

As illustrated in Figure 10, in one embodiment, a photovoltaic device 1000 is provided. The device 1000 comprises an n-type transparent conducting layer 1010. A p-type semiconductor window layer 1012 having a dopant density of greater than about $1 \times 10^{18}$ per cubic centimeter is disposed over the n-type transparent conducting layer 1010. An n-type semiconductor layer 1014 having a dopant density of greater than about $1 \times 10^{17}$ per cubic centimeter is disposed over the p-type semiconductor window layer 1012. An n-type cadmium telluride absorber layer 1016 having a dopant density in range from about $1 \times 10^{15}$ per cubic centimeter to about $1 \times 10^{16}$ per cubic centimeter is disposed between the p-type semiconductor window layer 1012 and the n-type semiconductor layer 1014. Light 1018 enters the device 1000 through the n-type transparent conducting layer 1010 and the p-type semiconductor window layer 1012. A back contact layer 1020 is disposed over the n-type semiconductor layer 1014. In one embodiment a substrate layer (not shown in figure) may be disposed over the back contact layer to form a device 1000 with a substrate configuration. In one embodiment, the n-type transparent conducting layer 1010 may be disposed over a substrate (not shown in figure) to form a device 1000 with a superstrate configuration.

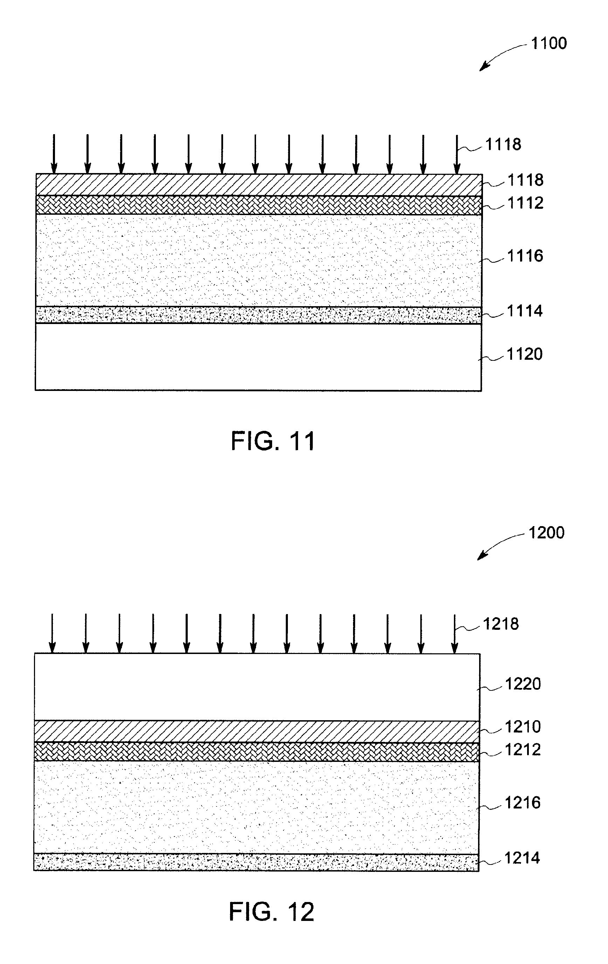

In certain embodiments, the n-type semiconductor layer 114 comprises at least one transparent conducting oxide selected from the group consisting of indium tin oxide, indium oxide, tin oxide, zinc oxide, aluminum doped zinc oxide, gallium doped zinc oxide, fluorine doped tin oxide, and indium zinc oxide. As illustrated in Figure 11, a photovoltaic device 1100 is provided. The device 1100 comprises a first n-type transparent conducting layer 1110. A p-type semiconductor window layer 1112 having a dopant density of greater than about $1 \times 10^{18}$ per cubic centimeter is disposed over the first n-type transparent conducting layer 1110. A second n-type transparent conducting layer 1120 is disposed over the p-type semiconductor window layer 1112. An n-type cadmium telluride absorber layer 1114 having a dopant density in a range from about $1 \times 10^{15}$ per cubic centimeter to about $1 \times 10^{16}$ per cubic centimeter is disposed between the p-type semiconductor window layer 1112 and the n-type semiconductor layer 1114. Light 1118 enters the device 1100 through the n-type transparent conducting layer 1110 and the p-type semiconductor window layer 1112. In one embodiment a substrate layer 1120 may be disposed over the second n-type transparent conducting layer 1120 to form a device 1100 with a substrate configuration. In one embodiment, the n-type transparent conducting layer 1110 may be disposed over a substrate (not shown in figure) to form a device 1100 with a superstrate configuration. In one embodiment, the device 1100 is a bifacial device. As used herein the term bifacial means that light can enter the device either through the first n-type transparent conducting layer 1110 and/or through the second n-type transparent conducting layer 1114. In one embodiment, the substrate 1120 used in either of the configurations, i.e., in the substrate or in the superstrate configuration, is transparent. In one embodiment, the first n-type conducting layer 1110 functions as the front contact layer and the second n-type conducting layer 1114 functions as the back contact layer.

As illustrated in Figure 12, a photovoltaic device 1200 is provided. The device 1200 comprises an n-type transparent conducting layer 1210. A p-type semiconductor window layer 1212 having a dopant density of greater than about 1 x $10^{18}$ per cubic centimeter is disposed over the n-type transparent conducting layer 1210. An n-type semiconductor layer 1214 is disposed over the p-type window layer 1212. An n-type cadmium telluride absorber layer 1216 having a dopant density in range from about 1 x $10^{15}$ per cubic centimeter to about 1 x $10^{16}$ per cubic centimeter is disposed between the p-type semiconductor window layer 1212 and the n-type semiconductor layer 1214. A second n-type transparent conducting layer 1220 is disposed over the n-type semiconducting layer 1214. In one embodiment, light 1218 enters the device 1200 through the first n-type transparent conducting layer 1210. In another embodiment, light 1218 enters the device 1200 through the second n-type transparent conducting layer 1220.

In still yet another embodiment, a photovoltaic device 1300 is provided. The device 1300 comprises a p-type transparent conducting layer 1310. A p-type semiconductor window layer 1312 is disposed over the p-type transparent conducting layer 1310. An n-type semiconductor layer 1314 is disposed over the p-type semiconductor window layer 1312. An n-type cadmium telluride absorber layer 1316 is disposed between the p-type semiconductor window layer 1312 and the n-type semiconductor layer 1314. Light 1318 enters the device 1300 through the p-type transparent conducting layer 1310 and the p-type semiconductor window layer 1312. In some embodiments, where the device comprises a p-type transparent conducting layer 1310, the p-type transparent conducting layer 1310 may assist in relaxing the requirement on the p-type semi-conducting layer 1312 with regard to minimizing the barrier for charge to cross the interface between the p-type transparent conducting layer 1310 and the p-type semiconductor window layer 1312.

Yet another embodiment is a method for making the devices described above. The method comprises disposing layers such as layers 110, 112, 114, and 116 in a photovoltaic device 100. The layers may be disposed using a wide variety of methods including closed-space sublimation, electro chemical deposition, chemical bath deposition, vapor transport deposition, and other physical or chemical vapor deposition.

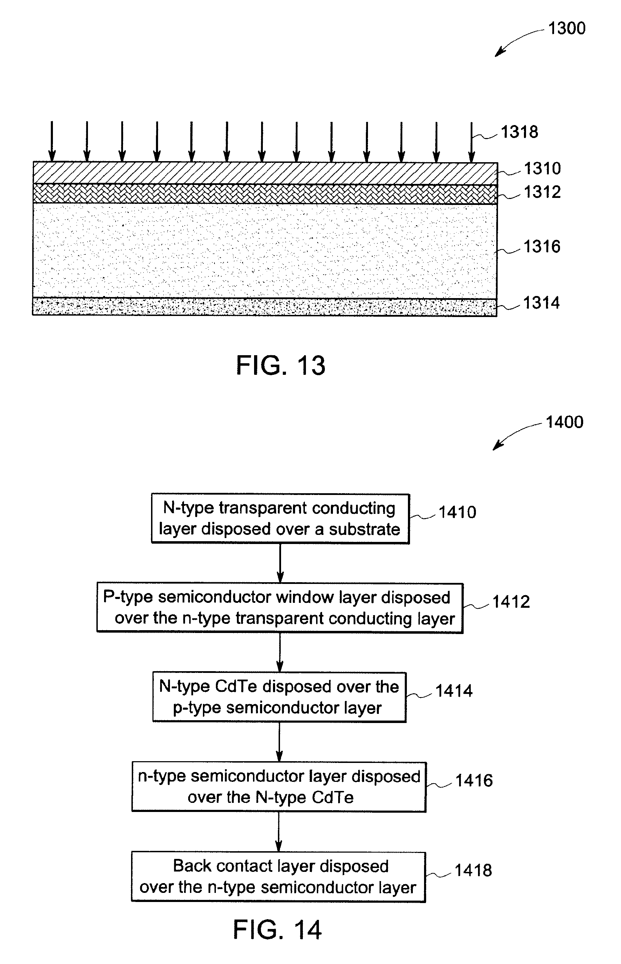

Referring to Figure 14 a schematic 1400 of a method to make a photovoltaic device as shown in Figure 4 in accordance with certain embodiments of the present invention is illustrated. In one embodiment, in a first step 1410 an n-type transparent conducting layer 410 is disposed over a substrate 420. In a second step 1412, a p-type semiconductor window layer 412 is disposed over the n-type transparent conducting layer 410. In a third step 1414, an n-type cadmium telluride absorber layer 416 is disposed over the p-type semiconductor window layer 412. In a fourth step 1416, an n-type semiconductor layer 414 is disposed over the n-type cadmium telluride absorber layer 416. Thus, the n-type cadmium telluride absorber layer 416 is disposed between the p-type semiconductor window layer 412 and the n-type semiconductor layer 414. In fifth step 1418, a back contact layer 418 is disposed over the n-type semiconductor layer 414 to form a device 400.

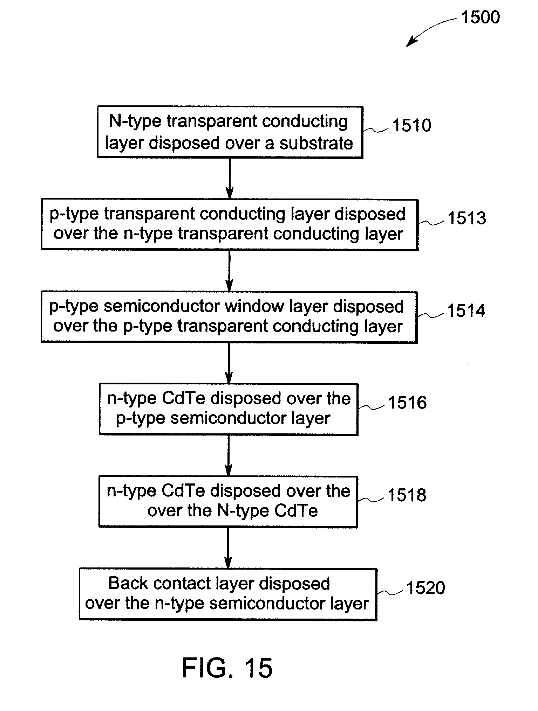

Referring to Figure 15 a schematic 1500 of a method to make a photovoltaic device as shown in Figure 7 in accordance with certain embodiments of the present invention is illustrated. In a first step 1510, a back contact layer 722 is disposed over a substrate 724. In a second step 1512, an n-type semiconductor layer 716 is disposed over the back contact layer 722. In a third step 1514, an n-type cadmium telluride absorber layer 718 is disposed over the n-type semiconductor layer 716. In a fourth step 1516, a p-type semiconductor window layer 714 is disposed over an n-type cadmium telluride absorber layer 718. In a fifth step 1518, a p-type transparent conducting layer 712 is disposed over the p-type semiconductor window layer 714. In a sixth step 1520, an n-type transparent conducting layer 710 is disposed over the p-type transparent conducting layer 712 to form the device 700.

Typically, the efficiency of a solar cell is defined as the electrical power that can be extracted from a module divided by the power density of the solar energy incident on the cell surface. Using Figure 4 as a reference, the incident light 422 passes through the substrate 420, n-type semiconductor layer 410 (front contact layer), and p-type semiconductor window layer 412 before it is absorbed in the n-type cadmium telluride absorber layer 116, where the conversion of the light energy to electrical energy takes place via the creation of electron-hole pairs. There are four key performance metrics for photovoltaic devices: (1) Short-circuit current density ($J_{SC}$) is the current density at zero applied voltage (2) Open circuit voltage ($V_{OC}$) is the potential between the anode and cathode with no current flowing. At $V_{OC}$ all the electrons and holes recombine within the device. This sets an upper limit for the work that can be extracted from a single electron-hole pair. (3) Fill factor (FF) equals the ratio between the maximum power that can be extracted in operation and the maximum possible for the cell under evaluation based on its $J_{SC}$ and $V_{OC}$. Energy conversion efficiency ($\eta$) depends upon both the optical transmission efficiency and the electrical conversion efficiency of the device, and is defined as:

$$\eta = J_{SC} \, V_{OC} \, FF/P_S$$

with (4) $P_S$ being the incident solar power. The relationship shown in the equation does an excellent job of determining the performance of a solar cell. However, the three terms in the numerator are not totally independent factors and typically, specific improvements in the device processing, materials, or design may impact all three factors.

Photovoltaic properties of any heterojunction-based solar cells considerably depend on the recombination centres present in the components of the heterojunction, and especially in the presence of recombination centres at the interface of the heterojunction. These recombination centres can be due to structural defects of the crystal lattice in the vicinity of the interface or in the bulk of the junction. Detailed electrical characterization of the heterojunctions can reveal recombination centres due to different defects or impurities and can potentially their influence on solar cell performance. With a direct energy band gap of 1.45 electron Volts and a high optical absorption coefficient, cadmium telluride is a very suitable absorber material for photovoltaic cells, especially, thin film solar cells. As mentioned earlier, conventional thin film p-type cadmium telluride/n-type cadmium sulfide photovoltaic cells with a small area have shown long-term stable performance and high conversion efficiency upto about 16 percent. However, the efficiencies of industrial, polycrystalline p-type cadmium telluride/n-type cadmium sulfide modules with large areas are still less than 11 percent. An alternative approach as discussed herein, includes in one embodiment, a heterojunction formed between the p-type semiconductor window layer 112 and the n-type cadmium telluride layer 116. The better lattice match resulting at the heterojunction may result in a reduction in the number of recombination centres in the junction area and thus assist in providing a solar cell with an improved performance. One other difference between a cadmium sulfide window layer and the p-type semiconductor window layer includes the inherent existence of the cadmium sulfide window layer as an n-type layer. Since cadmium telluride may be easily doped to form an n-type cadmium telluride, it may be associated with the p-type semiconductor window layer.

While only certain features of the invention have been illustrated and described herein, many modifications and changes will occur to those skilled in the art. It is, therefore, to be understood that the appended claims are intended to cover all such modifications and changes as fall within the true spirit of the invention.

Various aspects and embodiments of the present invention are defined by the following numbered clauses:

1. A photovoltaic device comprising:

a transparent conducting layer;

a p-type semiconductor window layer disposed over the transparent conducting layer;

an n-type semiconductor layer disposed over the p-type semiconductor window layer; and

an n-type cadmium telluride absorber layer disposed between the p-type semiconductor window layer and the n-type semiconductor layer.

2. The photovoltaic cell of clause 1, wherein the p-type semiconductor window layer and the n-type cadmium telluride each have a corresponding band-gap, wherein the band-gap of the p-type semiconductor window layer is greater than the band-gap of the n-type cadmium telluride layer.

3. The photovoltaic cell of any preceding clause, the n-type semiconductor layer and the n-type cadmium telluride each have a corresponding band-gap, wherein the band-gap of the n-type semiconductor layer is greater than or equal to the band-gap of the n-type cadmium telluride layer.

4. The photovoltaic cell of any preceding clause, wherein the transparent conducting layer comprise an n-type transparent conducting layer.

5. The photovoltaic cell of any preceding clause, wherein the n-type transparent conducting layer comprises at least one transparent conducting oxide selected from the group consisting of indium tin oxide, indium oxide, tin oxide, zinc oxide, aluminum doped zinc oxide, gallium doped zinc oxide, fluorine doped tin oxide, and indium zinc oxide.

6. The photovoltaic cell of any preceding clause, wherein a dopant density within the n-type transparent conducting layer is in a range from about $1 \times 10^{19}$ per cubic centimeter to about $1 \times 10^{21}$ per cubic centimeter.

7. The photovoltaic cell of any preceding clause, further comprising a p-type transparent conducting layer disposed between the n-type transparent conducting layer and the p-type semiconductor window layer.

8. The photovoltaic cell of any preceding clause, wherein the p-type transparent conducting layer comprises copper aluminum oxide ($CuAlO_2$), strontium copper oxide ($SrCu_2O_2$ $BaCuEF$, $LaCuOD$, $MCuO(S_{1-y},Se_y)$, strontium copper zinc oxy sulfide ($Sr_2Cu_2ZnO_2S_2$) or strontium copper gallium oxy sulfide ($Sr_2CuGaO_3S$), wherein 'E' comprises sulfur, selenium, or tellurium, wherein 'D' comprises sulfur, selenium, or tellurium, wherein 'M' comprises praseodymium, neodymium, or a lanthanide and wherein y has a value of 0 or less than or equal 1.

9. The photovoltaic cell of any preceding clause, wherein a dopant density within the p-type transparent conducting layer is in a range from about $1 \times 10^{18}$ per cubic centimeter to about $1 \times 10^{20}$ per cubic cen-

timeter.

10. The photovoltaic cell of any preceding clause, wherein the transparent conducting layer comprise a p-type transparent conducting layer.

11. The photovoltaic cell of any preceding clause, wherein the p-type transparent conducting layer comprises copper aluminum oxide ($CuAlO_2$) strontium copper oxide ($SrCu_2O_2$), BaCuEF, LaCuOD, $MCuO(S_{1-y},Se_y)$, strontium copper zinc oxy sulfide ($Sr_2Cu_2ZnO_2S_2$) or strontium copper gallium oxy sulfide ($Sr_2CuGaO_3S$), wherein 'E' comprises sulfur, selenium, or tellurium, wherein 'D' comprises sulfur, selenium, or tellurium, wherein 'M' comprises praseodymium, neodymium, or a lanthanide and wherein y has a value of 0 or less than or equal 1.

12. The photovoltaic cell of any preceding clause, wherein a dopant density within the p-type transparent conducting layer is in a range from about $1 \times 10^{18}$ per cubic centimeter to about $1 \times 10^{20}$ per cubic centimeter.

13. The photovoltaic cell of any preceding clause, further comprising an n-type transparent conducting layer disposed over the n-type semiconductor layer.

14. The photovoltaic cell of any preceding clause, wherein the n-type cadmium telluride absorber layer comprises a dopant material comprising cadmium, aluminum, indium, iodine, or gallium.

15. The photovoltaic cell of any preceding clause, wherein a dopant density within the n-type cadmium telluride absorber layer is in a range from about $1 \times 10^{15}$ per cubic centimeter to about $1 \times 10^{17}$ per cubic centimeter.

16. The photovoltaic cell of any preceding clause, wherein the p-type semiconductor window layer comprises zinc telluride, magnesium telluride, magnesium selenide, zinc-magnesium-sulfide-selenide (ZnMgSSe), nitrogen doped zinc-magnesium-beryllium-selenide (ZnMgBeSe:N), copper aluminum oxide ($CuAlO_2$), strontium copper oxide ($SrCu_2O_2$), copper oxide ($Cu_2O$), hydrogenated amorphous silicon, amorphous silicon carbide (a-SiC:H), BaCuEF, LaCuOD, $MCuO(S_{1-y},Se_y)$, strontium copper zinc oxy sulfide ($Sr_2Cu_2ZnO_2S_2$) or strontium copper gallium oxy sulfide ($Sr_2CuGaO_3S$), wherein 'E' comprises sulfur, selenium, or tellurium, wherein 'D' comprises sulfur, selenium, or tellurium, wherein 'M' comprises praseodymium, neodymium, or a lanthanide and wherein y has a value of 0 or less than or equal 1.

17. The photovoltaic cell of any preceding clause, wherein a dopant density within the p-type semiconductor window layer is in a range from about $1 \times 10^{13}$ per cubic centimeter to about $1 \times 10^{19}$ per cubic centimeter.

18. The photovoltaic cell of any preceding clause, wherein the n-type semiconductor layer comprises cadmium telluride, cadmium sulfide, zinc telluride, cadmium zinc telluride, cadmium selenide, or zinc selenide, or n-type hydrogenated amorphous silicon hydride.

19. The photovoltaic cell of any preceding clause, wherein the n-type semiconductor layer comprises at least one transparent conducting oxide selected from the group consisting of indium tin oxide, indium oxide, tin oxide, zinc oxide, aluminum doped zinc oxide, gallium doped zinc oxide, fluorine doped tin oxide, and indium zinc oxide.

20. The photovoltaic cell of any preceding clause, wherein a dopant density within the n-type semiconductor layer is in a range from about $1 \times 10^{16}$ per cubic centimeter to about $1 \times 10^{21}$ per cubic centimeter.

21. The photovoltaic cell of any preceding clause, further comprising a back contact layer disposed over the n-type semiconductor layer.

22. The photovoltaic cell of any preceding clause, further comprising at least one substrate disposed over at least the n-type semiconductor layer or the n-type transparent conducting layer

23. A photovoltaic device comprising:

an n-type transparent conducting layer;

a p-type semiconductor window layer disposed over the n-type transparent conducting layer;

an n-type semiconductor layer disposed over the p-type semiconductor window layer; and

an n-type cadmium telluride absorber layer disposed between the p-type semiconductor window layer and the n-type semiconductor layer.

24. A photovoltaic device comprising:

an n-type transparent conducting layer;

a p-type transparent conducting layer disposed over the n-type transparent conducting layer;

a p-type magnesium telluride window layer disposed over the p-type transparent conducting layer;

an n-type cadmium telluride layer having a dopant density of greater than about $1 \times 10^{17}$ per cubic centimeter; and

an n-type cadmium telluride absorber layer having a dopant density in the range of about $1 \times 10^{15}$ per cubic centimeter to about $1 \times 10^{16}$ per cubic centimeter disposed between the p-type magnesium telluride layer and the n-type cadmium telluride layer having a dopant density of greater than about $1 \times 10^{17}$ per cubic centimeter.

25. A photovoltaic device comprising:

an n-type transparent conducting layer;

a p-type semiconductor window layer having a dopant density of greater than about $1 \times 10^{18}$ per cubic centimeter disposed over the n-type transparent conducting layer;

an n-type semiconductor layer having a dopant density of greater than about $1 \times 10^{17}$ per cubic centimeter disposed over the p-type semiconductor; and

an n-type cadmium telluride absorber layer having a dopant density in the range of about $1 \times 10^{15}$ per cubic centimeter to about $1 \times 10^{16}$ per cubic centimeter; disposed between the p-type semiconductor window layer and the n-type layer having a dopant density of greater than about $1 \times 10^{17}$ per cubic centimeter.

26. The photovoltaic device of any preceding clause, further comprising a second n-type transparent conducting layer disposed over the n-type semiconductor layer.

27. A photovoltaic device comprising:

a first n-type transparent conducting layer;

a p-type semiconductor window layer having a dopant density of greater about $1 \times 10^{18}$ per cubic centimeter disposed over the first n-type transparent conducting layer;

a second n-type transparent conducting layer disposed over the p-type semiconductor window layer; and

an n-type cadmium telluride absorber layer having a dopant density in the range of about $1 \times 10^{15}$ per cubic centimeter to about $1 \times 10^{16}$ per cubic centimeter disposed between the p-type semiconductor window layer and the second n-type transparent conducting layer.

28. The photovoltaic device of any preceding clause, further comprising a second n-type transparent conducting layer disposed over the n-type semiconductor layer.

29. A photovoltaic device comprising:

a p-type transparent conducting layer;

a p-type semiconductor window layer disposed over the p-type transparent conducting layer;

an n-type semiconductor layer disposed over the p-type semiconductor window layer; and

an n-type cadmium telluride absorber layer disposed between the p-type semiconductor window layer and the n-type semiconductor layer.

**Claims**

1. A photovoltaic device (100) comprising:

   a transparent conducting layer (110); a p-type semiconductor window layer (112) disposed over the transparent conducting layer (110);
   an n-type semiconductor layer (114) disposed over the p-type semiconductor window layer (112); and
   an n-type cadmium telluride absorber layer (116) disposed between the p-type semiconductor window layer (112) and the n-type semiconductor layer (114).

2. The photovoltaic device (100) of claim 1, wherein the p-type semiconductor window layer (112) and the n-type cadmium telluride (116) each have a corresponding band-gap, wherein the band-gap of the p-type semiconductor window layer is greater than the band-gap of the n-type cadmium telluride layer.

3. The photovoltaic device (100) of any preceding claim, the n-type semiconductor layer (114) and the n-type cadmium telluride (116) each having a corresponding band-gap, wherein the band-gap of the n-type semiconductor layer is greater than or equal to the band-gap of the n-type cadmium telluride layer.

4. The photovoltaic device (100) of any preceding claim, wherein the transparent conducting layer (110) comprise an n-type transparent conducting layer, wherein a dopant density within the n-type transparent conducting layer is in a range from about $1 \times 10^{19}$ per cubic centimeter to about $1 \times 10^{21}$ per

cubic centimeter.

5. The photovoltaic device (100) of any preceding claim, further comprising a p-type transparent conducting layer (110) disposed between the n-type transparent conducting layer and the p-type semiconductor window layer (112), wherein a dopant density within the p-type transparent conducting layer is in a range from about $1 \times 10^{18}$ per cubic centimeter to about $1 \times 10^{20}$ per cubic centimeter.

6. The photovoltaic device (100) of any preceding claim, wherein the transparent conducting layer (110) comprises a p-type transparent conducting layer, wherein a dopant density within the p-type transparent conducting layer is in a range from about $1 \times 10^{18}$ per cubic centimeter to about $1 \times 10^{20}$ per cubic centimeter.

7. The photovoltaic device (100) of any preceding claim, wherein a dopant density within the n-type cadmium telluride absorber layer (116) is in a range from about $1 \times 10^{15}$ per cubic centimeter to about $1 \times 10^{17}$ per cubic centimeter.

8. The photovoltaic device (100) of any preceding claim, wherein a dopant density within the p-type semiconductor window layer (112) is in a range from about $1 \times 10^{13}$ per cubic centimeter to about $1 \times 10^{19}$ per cubic centimeter.

9. The photovoltaic device (100) of any preceding claim, wherein a dopant density within the n-type semiconductor layer (114) is in a range from about $1 \times 10^{16}$ per cubic centimeter to about $1 \times 10^{21}$ per cubic centimeter.

10. A photovoltaic device (100) comprising:

    an n-type transparent conducting layer (110);
    a p-type transparent conducting layer (112) disposed over the n-type transparent conducting layer;
    a p-type magnesium telluride window layer disposed over the p-type transparent conducting layer;
    an n-type cadmium telluride layer having a dopant density of greater than about $1 \times 10^{17}$ per cubic centimeter; and
    an n-type cadmium telluride absorber layer (116) having a dopant density in the range of about $1 \times 10^{15}$ per cubic centimeter to about $1 \times 10^{16}$ per cubic centimeter disposed between the p-type magnesium telluride layer and the n-type cadmium telluride layer having a dopant density of greater than about $1 \times 10^{17}$ per cubic centimeter.

11. A photovoltaic device (100) comprising:

    an n-type transparent conducting layer (110);
    a p-type semiconductor window layer (112) having a dopant density of greater than about $1 \times 10^{18}$ per cubic centimeter disposed over the n-type transparent conducting layer;
    an n-type semiconductor layer (114) having a dopant density of greater than about $1 \times 10^{17}$ per cubic centimeter disposed over the p-type semiconductor; and
    an n-type cadmium telluride absorber layer (116) having a dopant density in the range of about $1 \times 10^{15}$ per cubic centimeter to about $1 \times 10^{16}$ per cubic centimeter; disposed between the p-type semiconductor window layer and the n-type layer having a dopant density of greater than about $1 \times 10^{17}$ per cubic centimeter.

100

118

110

112

116

114

## FIG. 1

200

220

210

212

216

214

218

## FIG. 2

FIG. 3

FIG. 4

EP 2 413 384 A2

**FIG. 5**

**FIG. 6**

16

700

720

710
712
714

718

716

722

724

**FIG. 7**

800

820

824

810
812
814

818

816

822

**FIG. 8**

900

922
910
912
914
918
916
920

FIG. 9

1000

1018
1010
1012
1016
1014
1020

FIG. 10

1100

1118

1118
1112

1116

1114

1120

FIG. 11

1200

1218

1220

1210
1212

1216

1214

FIG. 12

_1300_

_1318_
_1310_
_1312_
_1316_
_1314_

# FIG. 13

_1400_

| N-type transparent conducting layer disposed over a substrate | _1410_ |

↓

| P-type semiconductor window layer disposed over the n-type transparent conducting layer | _1412_ |

↓

| N-type CdTe disposed over the p-type semiconductor layer | _1414_ |

↓

| n-type semiconductor layer disposed over the N-type CdTe | _1416_ |

↓

| Back contact layer disposed over the n-type semiconductor layer | _1418_ |

# FIG. 14

1500

N-type transparent conducting layer disposed over a substrate — 1510

p-type transparent conducting layer disposed over the n-type transparent conducting layer — 1513

p-type semiconductor window layer disposed over the p-type transparent conducting layer — 1514

n-type CdTe disposed over the p-type semiconductor layer — 1516

n-type CdTe disposed over the over the N-type CdTe — 1518

Back contact layer disposed over the n-type semiconductor layer — 1520

FIG. 15